(19) Europäisches Patentamt / European Patent Office / Office européen des brevets

(11) **EP 2 296 000 B1**

(12) **EUROPEAN PATENT SPECIFICATION**

(45) Date of publication and mention
of the grant of the patent:
**12.03.2014 Bulletin 2014/11**

(51) Int Cl.:
***G01R 33/3415*** (2006.01)

(21) Application number: **09290696.5**

(22) Date of filing: **10.09.2009**

(54) **Parallel excitation of nuclear spins with local SAR control**

Parallele Anregung von Kernspins mit kontrolliertem lokalen SAR

Excitation parallèle de spins nucléaires avec SAR local contrôlé

(84) Designated Contracting States:
**AT BE BG CH CY CZ DE DK EE ES FI FR GB GR HR HU IE IS IT LI LT LU LV MC MK MT NL NO PL PT RO SE SI SK SM TR**

(43) Date of publication of application:
**16.03.2011 Bulletin 2011/11**

(73) Proprietor: **Commissariat à l'Énergie Atomique et aux Énergies Alternatives
75015 Paris (FR)**

(72) Inventors:
• **Cloos, Martijn
91400 Gometz-La-Ville (FR)**
• **Boulant, Nicolas
91190 Gif Sur Yvette (FR)**

(74) Representative: **Priori, Enrico et al
Cabinet Orès
36, rue de St. Pétersbourg
75008 Paris (FR)**

(56) References cited:
**US-A1- 2007 247 155        US-A1- 2009 108 842**

• **GRISSOM W ET AL: "Spatial domain method for the design of RF pulses in multicoil parallel excitation" MAGNETIC RESONANCE IN MEDICINE, ACADEMIC PRESS, DULUTH, MN, US, vol. 56, no. 3, 1 September 2006 (2006-09-01), pages 620-629, XP002475615 ISSN: 0740-3194**

• **YIP C-Y ET AL: "Iterative RF Pulse Design for Multidimensional, Small-Tip-Angle Selective Excitation" MAGNETIC RESONANCE IN MEDICINE, ACADEMIC PRESS, DULUTH, MN, US, vol. 54, 1 January 2005 (2005-01-01), pages 908-917, XP002554152 ISSN: 0740-3194 [retrieved on 2005-09-09]**

• **GRAESSLIN I ET AL: "SAR hotspot reduction by temporal averaging in parallel transmission" PROCEEDINGS OF THE INTERNATIONAL SOCIETY FOR MAGNETIC RESONANCE IN MEDICINE, 17TH SCIENTIFIC MEETING AND EXHIBITION, HONOLULU, HAWAII, USA, 18-24 APRIL 2009, 18 April 2009 (2009-04-18), page 176, XP002564610**

• **ZELINSKI A C ET AL: "Designing RF Pulses With Optimal Specific Absorption Rate (SAR) Characteristics And Exploring Excitation Fidelity, SAR And Pulse Duration Tradeoffs" INTERNATIONAL SOCIETY FOR MAGNETIC RESONANCE IN MEDICINE.SCIENTIFIC MEETING AND EXHIBITION. PROCEEDINGS, INTERNATIONAL SOCIETY FOR MAGNETIC RESONANCE IN MEDICINE, US, vol. 15, 1 January 2007 (2007-01-01), page 1699, XP002533633 ISSN: 1524-6965**

• **BRUNNER D O ET AL: "Enforcing strict constraints in multiple-channel RF pulse optimization" INTERNATIONAL SOCIETY FOR MAGNETIC RESONANCE IN MEDICINE.SCIENTIFIC MEETING AND EXHIBITION. PROCEEDINGS, INTERNATIONAL SOCIETY FOR MAGNETIC RESONANCE IN MEDICINE, US, vol. 15, 1 January 2007 (2007-01-01), page 1690, XP002533631 ISSN: 1524-6965**

EP 2 296 000 B1

- VAN DEN BERG C A T ET AL: "Simultaneous B1+ Homogenization and Specific Absorption Rate Hotspot Suppression Using a Magnetic Resonance Phased Array Transmit Coil" MAGNETIC RESONANCE IN MEDICINE, ACADEMIC PRESS, DULUTH, MN, US, vol. 57, 1 January 2007 (2007-01-01), pages 577-586, XP002533629 ISSN: 0740-3194
- IBRAHIM T S ET AL: "A Whole-Body 7 Tesla RF Excitation Scheme with Much Improved B1+ Field Homogeneity and Local/Global SARs over Quadrature Excitation" INTERNATIONAL SOCIETY FOR MAGNETIC RESONANCE IN MEDICINE.SCIENTIFIC MEETING AND EXHIBITION. PROCEEDINGS, INTERNATIONAL SOCIETY FOR MAGNETIC RESONANCE IN MEDICINE, US, vol. 15, 1 January 2007 (2007-01-01), page 1013, XP002533630 ISSN: 1524-6965
- YINAN LIU ET AL: "Minimal-SAR RF pulse optimization for parallel transmission in MRI" ENGINEERING IN MEDICINE AND BIOLOGY SOCIETY, 2008. EMBS 2008. 30TH ANNUAL INTERNATIONAL CONFERENCE OF THE IEEE, IEEE, PISCATAWAY, NJ, USA, 20 August 2008 (2008-08-20), pages 5774-5777, XP031509326 ISBN: 978-1-4244-1814-5
- LATTANZI R ET AL: "Electrodynamic constraints on homogeneity and radiofrequency power deposition in multiple coil excitations" MAGNETIC RESONANCE IN MEDICINE, ACADEMIC PRESS, DULUTH, MN, US, vol. 61, 22 January 2009 (2009-01-22), pages 315-334, XP002564611

**Description**

The invention relates to a method of exciting nuclear spins in a sample, in particular a human or animal body or a part thereof such as a human head, and to the application of such a method to magnetic nuclear resonance imaging (MRI).

The invention applies to MRI systems using parallel transmission and is particularly aimed at reducing, or otherwise control, the local specific absorption rate (SAR) of the sample.

Specific absorption rate (SAR) is defined as the power absorbed per unit mass of tissue by a body exposed to a radio frequency (RF) electromagnetic field. For safety reasons, both global (averaged over the whole exposed body) and local (averaged over a small mass of tissue, typically 1g or 10g) SAR limits are enforced.

The problem of high local SAR plays a particularly important role in high-magnetic field MRI. High magnetic field ($B_0$) MRI yields an improved signal to noise ratio, and therefore a better image quality. The spin resonance frequency, or Larmor frequency is proportional to the external field strength; as a result, high field strength MRI requires high-frequency RF ($B_1^+$) fields to excite the nuclear spins. Due to the dielectric properties of the human or animal body, the wavelengths inside the body are reduced considerably compared to vacuum; as a consequence a complex pattern of wave interferences occurs inside the sample so that a highly inhomogeneous magnetic and electric field distribution can emerge. At a magnetic field strength of the order of 3T (for body MRI) or 7T (for head MRI) this can lead to the appearance of "hot spots" with high local SAR.

For known probe geometries with fixed amplitude and phase relations between coil elements, the SAR distribution in the body can be computed as a function of the local conductivity of the sample ($\sigma(\vec{r})$ expressed in S/m), its local mass density ($\rho(\vec{r})$, expressed in g/m$^3$), the duration of the pulse (L, in s) and the local electric field strength ($\overrightarrow{E(\vec{r},t)}$ in V/m):

$$SAR(\vec{r}) = \frac{\sigma(r)}{2\rho(r)} \frac{1}{L} \int_0^L |\vec{E}(\vec{r},t)|^2 \, dt \qquad (1)$$

Based on computer simulations, a safety factor can then be determined to guaranty patient safety. More precisely, current clinical MRI scanners are provided with a SAR monitor consisting of a device that measures the power transmitted to the transmit coil(s). Based on simulations performed by the manufacturer, a formula is derived to calculate if the maximum allowed power, based on the patients weight and length. In a normal scanner this approach allows sufficient power for clinical MRI applications.

Wave interferences inside the sample also lead to an inhomogeneous excitation fields ($B_1^+$), and therefore to an inhomogeneous excitation profile within the sample, resulting in inhomogeneous tissue contrast and signal intensity. As many MRI applications need homogeneous $B_1^+$ fields to yield high quality images, several methods have been proposed to achieve homogenous excitation profiles at high field strengths, including alternative coil designs [4, 5], shaped pulses [6, 7] and parallel transmission [8].

Parallel transmission is a particularly promising method to produce homogeneous excitations profiles at high field strengths [9 - 11] due to the increased number of degrees of freedom. This technique is based on the use of a plurality of transmit coils which are driven in parallel, independently from each other, to emit respective radio-frequency excitation pulses. The possibility to control phase and amplitude of each coil element, allows excitation pulses of short duration with good homogeneity at high fields [10 - 12]. But these additional degrees of freedom also make the problem of controlling the local SAR values much more complex. Indeed, in the case of parallel excitation, an almost infinite number of different pulse schemes can be implemented, each resulting in a different field distribution; as a consequence, merely monitoring the RF power transmitted by each coil is no longer sufficient, and the SAR distribution has to be computed, for each pulse scheme of interest, by applying equation (1) above, where the electric field ($\overrightarrow{E(\vec{r},t)}$ is given by the complex sum of the scaled ($\alpha_n(t)$) electric fields for each coil ($\overline{E}_n(\vec{r},t)$ - linearity being generally admitted:

$$\vec{E}(\vec{r},t) = \sum_n a_n(t) \vec{E}_n(\vec{r},t) \qquad (2)$$

In turn, the individual coil electric field contributions ($\overline{E}_n(\vec{r},t)$ are provided by numerical simulations in the presence of a numerical model of the sample (i.e. a human head).

Detailed analysis shows that, using parallel transmission at 7 Tesla, the worst-case scenario engenders the formation of an area with very high SAR (hot spot) [14]. It has also been shown that for tailor made excitation pulses the local SAR can be relatively large [13].

Yip [33] discloses a method for reducing the integrated power and the peak power radiated by individual coils in parallel MRI.

Habara [34] discloses a method of generating MRI pulses of limited power and with limited SAR.

Several methods have been proposed in the last few years to reduce the SAR during parallel transmission.

Zelinski [20] showed that, if the electric field distribution is known, global SAR minimization can be encompassed in the design procedure of the excitation pulse. It has also been shown that different minimization algorithms can converge to pulses with different SAR distributions [21].

More recently, temporal averaging was proposed as a method to reduce the local SAR [22, 23]: alternating between pulses in an MRI sequence, with different SAR distributions, out of a set of excitation pulses that share the desired excitation characteristics, i.e. spin flip angle and phase, the time average maximum local SAR can be reduced. It was suggested that pulses suitable for this purpose could be found by adding a limited number of control points during pulse design [24], i.e. by imposing a quadratic SAR constraint at these particular points. It was also shown that different k-space trajectories could produce different SAR distributions [25]. However, no method has been disclosed so far describing the design of pulses with different local SAR distributions and demonstrating comparable excitation properties within the set of RF pulses.

More generally, no known method exists for designing parallel transmission excitation schemes allowing control of the local SAR distribution within the sample. The invention aims at providing such a method.

According to claim 1, an object of the present invention is a method of exciting nuclear spins in a sample, wherein a plurality of transmit coils are driven in parallel to emit respective radio-frequency waves, the method comprising computing the waveforms of said excitation pulses by solving an optimization problem for minimizing the difference between the spatial distribution of nuclear spin excitation within said sample induced by said radio-frequency waves and a target spatial distribution of nuclear spin excitation . The method of the invention allows to control in a predetermined way the local specific absorption rate - SAR - distribution within the sample.

The fact that excitation pulses constitute the solution of a suitable optimization problem ensures a satisfactory homogeneity of the sample excitation; the cost function allows control of the local SAR distribution.

"Control" of the local SAR distribution can comprise minimizing the local SAR maximum value within the sample. Alternatively or additionally it can comprise ensuring that the local SAR takes its maximum value within a predetermined region of the sample, which in turn allows temporal averaging.

Particular embodiments of the method of the invention constitute the object of depending claims.

According to claim 16, a further object of the present invention is a method of performing nuclear magnetic resonance imaging of a sample comprising:

- determining a k-space trajectory for sampling the volume of said sample; and
- exciting nuclear spins in said sample by a method according to the invention, the optimization problem being solved for said k-space trajectory.

Advantageously, the sample can be a human or animal body, or a part thereof such as a human head.

Additional features and advantages of the present invention will become apparent from the subsequent description, taken in conjunction with the accompanying drawings, which show:

- Figure 1, a multi-coil MRI probe, suitable for carrying out the invention, used to image a human head;
- Figure 2, a flow-chart of a pulse design method according to the invention;
- Figure 3, four different k-space trajectories of the "spoke" type, suitable for for carrying out the invention;
- Figure 4, SAR maps illustrating the reduction of the local SAR maximum value obtained by a first embodiment of the invention;
- Figure 5, SAR maps illustrating the control of the local SAR maximum position obtained by a second embodiment of the invention; and
- Figure 6, the plots of the RF amplitudes of the excitation pulses of the embodiment of figure 5.

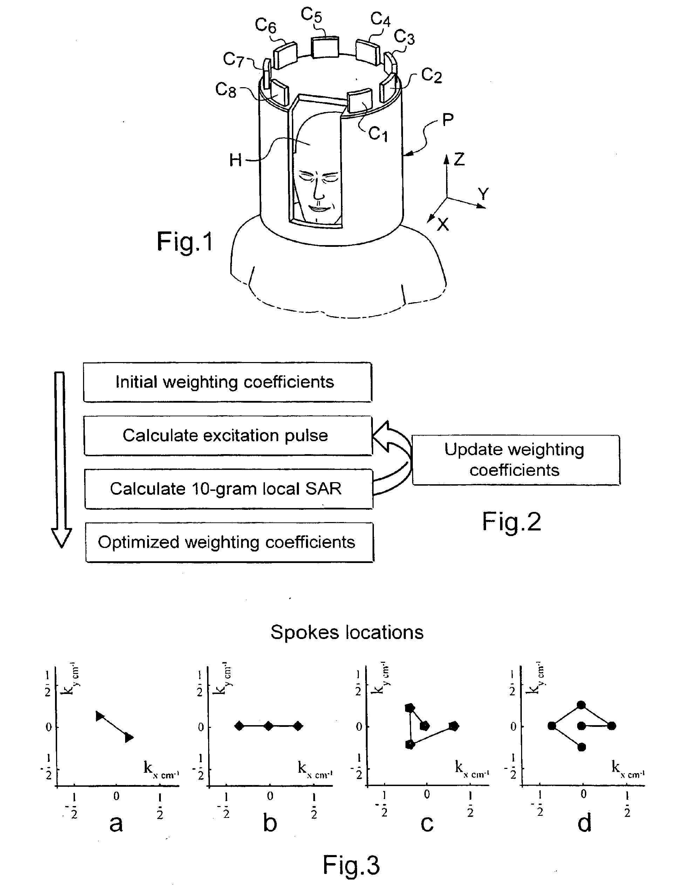

The invention will be described on the basis of a specific example, wherein a human head (Fig. 1, H) is imaged in vivo using a MRI probe P constituted by eight stripline magnetic dipoles (individual transmit-receive coils) $C_1$ - $C_8$ distributed in 40-degrees increments on a cylindrical surface of 27.6 cm diameter leaving an open space in front of the eyes of the patient (see figure 1). Finite element simulations ([28]) provides the $B_1^+$ maps of the individual coils of probe P, i.e. the maps of the RF excitation field emitted by each of the magnetic dipoles $C_1$ - $C_8$. As known in the prior art, $B_1^+$ maps can also be measured using special pulse sequences [26, 27].

Imaging is performed in the k-space using spokes trajectories, a method that has been demonstrated in vivo to produce homogeneous flip angles for slice selective excitation [10, 11, 25].

The RF pulses to be transmitted by each individual coil can be designed, for a given k-space trajectory, using the spatial domain method described by document [1]. The small-tip-angle approximation allows the transverse plane magnetization m(r), indicative of sample excitation, to be approximated by the Fourier integral of an excitation k-space trajectory ( $(\vec{kt})=[k_x(t),k_y(t),k_z(t)]$) weighted by a complex RF pulse (b(t)) and spatially weighted by the coil's complex transmit sensitivity ($B_1^+(\vec{r})$).

$$m(\vec{r}) = i\gamma m_0 B_1^+(\vec{r}) \int_0^T b(t) e^{i\gamma\Delta B_0(\vec{r})(t-T)} e^{i\vec{r}\cdot\vec{k}(t)} dt \tag{3}$$

where $\gamma$ is the gyromagnetic ratio, $m_0$ is the equilibrium magnetization magnitude, T is the pulse length, and $e^{i\gamma\Delta B_0(\vec{r})(t-T)}$ represents the phase acquired due to main field inhomogeneity $\Delta B_0(\vec{r})$. The k-space trajectory ($\vec{kt}$) is described by the time-reversed integration over a predefined set of gradient ($G_i(u)$) waveforms to be played during excitation i.e. for example for its x component $k_x(t) = -\gamma \int_t^T G_x(u)du$.

Exploiting linearity, in the small-tip-angle regime, Equation 3 can be generalized (Equation 4) by summation over the coil elements available for parallel transmission:

$$m(\vec{r}) = i\gamma m_0 \sum_n^N B_{1,n}^+(\vec{r}) \int_0^T b_n(t) e^{i\gamma\Delta B_0(\vec{r})(t-T)} e^{i\vec{r}\cdot\vec{k}(t)} dt \tag{4}$$

where N represents the total number of coils, $B_{1,n}^+(\vec{r})$ represents the complex transmit sensitivity map of, and $b_n(t)$ RF waveform played on, coil number n. Discretizing space and time, with $N_s$ and $N_t$ samples respectively, and writing the transverse magnetization $\overline{m}$ as a column vector, equation 4 can be approximated by:

$$\overline{m} = [D_1 A, \cdots, D_N A] \begin{bmatrix} b_1 \\ \vdots \\ b_N \end{bmatrix} = A_{tot} b_{tot} \tag{5}$$

where $D_n = \text{diag}\{B_{1,n}^+(\vec{r})\}$ is a diagonal matrix containing samples of the sensitivity map for each of the N coil elements, and the elements $a_{i,j}$ of matrix A are defined as $a_{i,j} = i\gamma m_0 B_1^+(\vec{r})\Delta t e^{i\gamma\Delta B_n(\vec{r}_i)(t_j-T)} e^{i\vec{r}_i\cdot\vec{k}(t_j)}$.

One wants to find a set of N RF waveforms $b_n$ (t) leading to a (discretized) magnetization profile which is as close as possible to a target profile $\overline{d}$ This is an inverse problem, and more precisely an optimization problem. According to the prior art, a single scalar Tikhonov parameter ($\lambda$) is introduced [1] in order to ensure that this optimization problem is wellconditioned. Effectively, the Tikhonov parameter introduces a cost function proportional to the integrated RF power, thereby suppressing solutions with large RF amplitudes. Accordingly, the optimization problem used for pulse design can be written:

$$\min_{b_{tot}}\{\|d - A_{tot} b_{tot}\|_2^2 + \lambda\|b_{tot}\|_2^2\} \tag{6}$$

where $\|\cdot\|_2$ designates the ubiquitous $L_2$ norm, i.e. the square root of the sum of squares of the elements.

The present inventors have discovered that using several independent Tikhonov parameters, associated to respective individual transmit coils - or to respective subsets of said coils - allow the control of the local SAR distribution in parallel excitation MRI. In the past, use of more than one Tikhonov parameter was considered of purely theoretical interest, and for practical pulse design a single parameter was generally used (see document [1]).

According to the invention - or, more precisely, a particular embodiment thereof - the optimization problem used for pulse design becomes:

$$\min_{b_{tot}}\{\|d - A_{tot}b_{tot}\|_2^2 + \|\lambda_M b_{tot}\|_2^2\} \qquad (7)$$

where $\lambda_M = diag\{\sqrt{\lambda_1},\cdots,\sqrt{\lambda_1},\sqrt{\lambda_2},\cdots,\sqrt{\lambda_2},\cdots,\sqrt{\lambda_N}\}$ , where N is the number of coils (eight, in the specific embodiment considered here). The diagonal of the $\lambda_M$ matrix contains N times $N_t$ elements, where $N_t$ is as above the number of time points defining the waveform to be played on each coil.

In a generalization of the method, the weighting factor can also vary over time, e.g. by taking $N_t$ different values during each group of pulses. In this case, equation (7) is changed by replacing $\lambda_i$ (i=1 - N) by $\lambda_{i,1}$ - $\lambda_{iN_t}$, and becomes

$$\lambda_M = diag\{\sqrt{\lambda_{1,1}},\cdots,\sqrt{\lambda_{1,N_t}},\sqrt{\lambda_{2,1}},\cdots,\sqrt{\lambda_{2,N_t}},\cdots,\sqrt{\lambda_{N,N_t}}\} = diag\{\sqrt{\lambda_1},\cdots,\sqrt{\lambda_{N\times N_t}}\} \text{ (7bis)}$$

According to the invention, coil-dependent Tikhonov parameters are set by means of iterative optimization. First, an excitation RF pulse is designed based on a set of identical Tikhonov parameters. Subsequently, the 10-gram average local SAR-maps is calculated using the returned RF pulse, the previously mentioned E field maps and the anatomical model of the head, providing σ(r) and ρ(r) as required by Equation 1. The 10-gram average is a quantity specified by the governmental institutions and it is equal to the SAR averaged over 10-gram of biological tissue (alternatively, the 1-gram average, or any other average, could also be used). Each iteration of the design algorithm consists in an update of at least one Tikhonov parameter, introduced according to a predetermined criterion, as it will be discussed later. Depending on the application, the procedure can then be stopped if desired local SAR criteria have been satisfied, a maximum number of iterations is reached, or the maximum local SAR drops below a given threshold. A flow-chart of the procedure is illustrated in Figure 2.

The method of the invention can be used to reduce the local SAR maximum value within the sample. To achieve such a goal, coil-dependent Tikhonov parameters are updated by increasing the weight of the coil(s) which is (are) considered as contributing the most to said SAR maximum, therefore introducing a higher penalty on the RF power emitted by said coil(s). For example, at each iteration, the Tikhonov parameter of the coil element which is closest to the spatial location of the 10-gram maximum local SAR value can be incremented by a predetermined amount, which can be constant or function of said maximum local SAR value. It is also possible to increment the Tikhonov parameters of more than one coil, the increment value depending on the distance between the spatial location of the maximum local SAR value and each coil. Alternatively, the Tikhonov parameter of the coil transmitting the highest RF power, or of all the coils whose RF power exceeds a predetermined standard, can be increased.

Alternatively, the method of the invention can be used to ensure that the local SAR takes its maximum value within a predetermined region of the sample. This can be obtained by incrementing the Tikhonov coefficient of the transmit coil which is closest to the local SAR maximum within the sample, excluding a predetermined region thereof: this way, after a few iterations, the "true" local SAR maximum will almost certainly be located within said predetermined region. Alternatively, a similar result can be obtained by incrementing the Tikhonov coefficient of the coil transmitting the highest RF-power, but excluding the coil (or a set of coils) which is (are) nearest to said predetermined region of the sample. Controlling the location of the local SAR maximum is useful as it allows moving the "hot spots" within the sample, providing temporal averaging of the local SAR.

Other control strategies of the local SAR distribution can be implemented, depending on the specific aim to be reached.

Some embodiments of the invention require the determination of the local SAR spatial distribution. This can be obtained by numerical simulations based on equation 2 (see [18, 19]), or by direct (references [2], [15 - 17]) or indirect (temperature, see reference [31]) measurements. Other embodiments only require the knowledge of the power emitted by each individual coil; this information is provided by conventional "SAR monitors". The invention has been described on the basis of conventional spatial domain optimization. However, this limitation is not essential: other design strategies exist, operating e.g. in the k-space [8]. All the design strategies which lead to an optimization problem can be modified according to the present invention. For example, document [29] describes a modified spatial domain method, wherein the phase of transverse magnetization m(r) is neglected.

In the description above, small flip angles have been assumed in order to obtain a linear equation for m(r). This is by no means essential, at least in principle, but use of a nonlinear equation for m(r) would make the numerical solution of the optimization problem extremely heavy. It should be noted that "additive" methods exist to generalize the linear approach to large flip angles [30, 32].

Tikhonov parameters are a particular class of weighting coefficients used to introduce cost functions in optimization problems. Other kind of cost functions, linear or nonlinear, can also be used to carry out the invention.

The technical results of the invention will be now discussed in detail with reference to two specific examples, illustrated by figures 3 to 6.

In the first example slice selective excitation pulses with a homogeneous excitation profile were designed using a "spokes" shaped k-space trajectory. Results obtained using four exemplary k-space trajectories, comprising 2, 3, 4, and 5-spokes respectively are compared. On figure 3, panels a to d illustrate said spokes trajectories in the $(k_x, k_y)$ plane. Such trajectories can be generated by appropriate magnetic field gradient waveforms, as it is well known in the art of MRI.

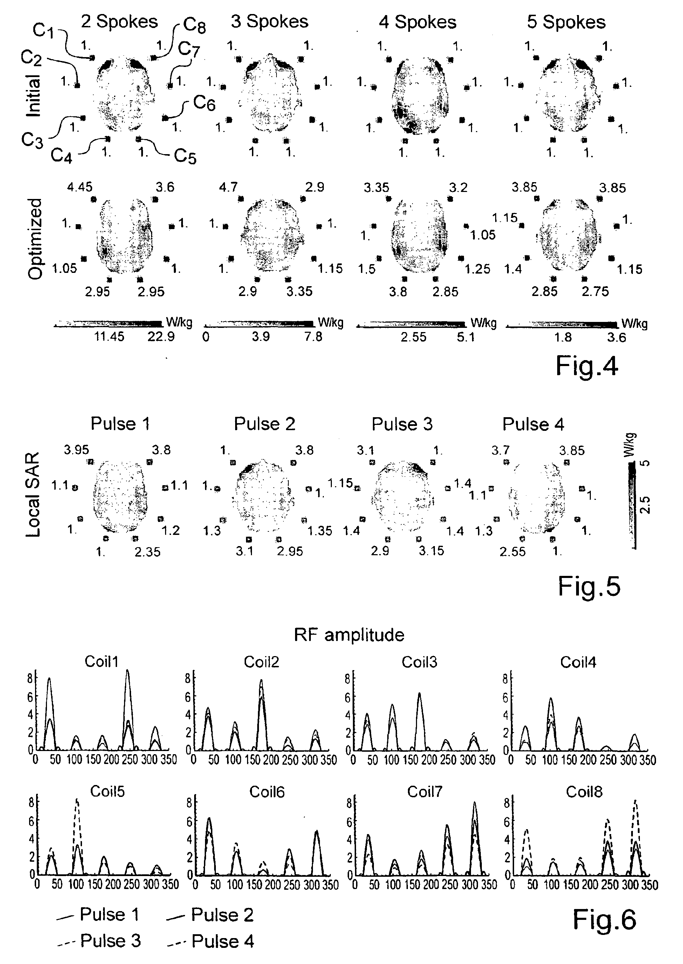

Simulated $B_1^+$ maps were used for pulse design, and the $\overrightarrow{E(r,t)}$ fields provided by simulations were used to calculate the local SAR distributions. The initial pulses were calculated by solving the optimization problem of equation (7), all the Tikhonov parameters being identically set to $10^{-5}$. The top row in figure 4 shows (in gray scale, where darker gray indicates higher SAR) the 10-gram local SAR distribution in the transverse slice containing the maximum 10-gram SAR over the head. Excitation pulses were optimized over 200 iterations of the coil dependent Tikhonov parameters. At each iteration the Tikhonov parameter associated with the coil element closest to the maximum 10-gram local SAR was increased by $5\times10^{-7}$. Optimized coil element dependent Tikhonov parameters (in $10^{-5}$ units), and 10-gram local SAR distributions are shown in the bottom row Figure 4. Using the presented method, for 200 iterations, the maximum 10-gram local SAR was reduced by more than a factor of 2 at the cost of a roughly 1-2% increase in flip angle error defined as the root mean square error of the flip angle, divided by the target flip angle (see table 1 here below).

Table 1

|  | Initial excitation pulse | | | Optimized excitation pulse | | |
|---|---|---|---|---|---|---|
|  | Maximum local SAR | Global SAR | Flip angle error | Maximum local SAR | Global SAR | Flip angle error |
| 2 Spokes | 23.03 | 2.78 | 6.8% | 9.62 | 2.30 | 10.2% |
| 3 Spokes | 7.84 | 1.14 | 4.7% | 3.69 | 1.06 | 6.7% |
| 4 Spokes | 5.14 | 0.75 | 3.4% | 2.60 | 0.64 | 5.2% |
| 5 Spokes | 3.64 | 0.49 | 3.1 % | 1.60 | 0.41 | 4.5% |

In the second example, slice selective excitation pulses with a homogeneous excitation profile were designed using the 5 "spokes" k-space trajectory of figure 3, panel d. The optimisation procedure was used to position the maximum local SAR at four different positions by systematically neglecting the SAR in one of the four axial quadrants of the human head during the optimization procedure. The results are illustrated on figure 5, which shows how the maximum local SAR, forming a well-defined "hot spot" (dark spot on the figure) is moved from the left side of the back of the head ("pulse 1") to the left side of the front of the head ("pulse 2"), then to the right side of the front of the head ("pulse 3") and finally to the right side of the back of the head ("pulse 4"). A correlation between the location of the hot spot and the values of the Tikhonov parameters is clearly visible. The flip angle and excitation phases obtained with the four "pulses" are comparable, as indicated by the respective complex correlation coefficients (Table 2).

Table 2

|  | Pulse 1 | Pulse 2 | Pulse 3 | Pulse 4 |
|---|---|---|---|---|
| Pulse 1 | 1 | 0.94+0.00i | 0.96+0.01 i | 0.95+0.01i |
| Pulse 2 |  | 1 | 0.90+0.01 i | 0.94+0.00i |
| Pulse 3 |  |  | 1 | 0.95+0.00i |
| Pulse 4 |  |  |  | 1 |

Figure 6 illustrates plots of the magnitude of the excitation pulses played at the different coils elements. As expected, the SAR hot spot location corresponds to where the highest peak RF amplitude is played. A coil dependent Tikhonov parameter therefore allows moving that hot spot around by reducing the integrated RF power over the corresponding coils.

In a MRI sequence, RF pulse and gradient / acquisition blocks are repeated a large number of times. Hence by using cyclically the 4 different and optimized pulses, with the same duty cycle, it is possible to obtain an average SAR map whose maximum can be reduced up to a factor of 4 compared to if only one pulse was used. Or, in other words, for the same maximum local SAR, it is possible to acquire data 4 times faster, a gain which is highly appreciable to obtain high resolution in vivo data in a reasonable time. This number 4 is only given as an example; it can be further increased via more optimization and calculations.

References:

[1] "Spatial domain method for the design of RF pulses in multicoil parallel excitation", W. Grissom, C.Y. Yip, Z. Zhang, V.A. Stenger, J.A. Fessler, and D. C. Noll, Magnetic Resonance in Medicine, 56, pp. 620-629 (2006).

[2] "Parallel Excitation With an Array of Transmit Coils", Y. Zhu, Magnetic Resonance in Medicine 51:775-784 (2004)

[3] "Autocalibrated Accelerated Parallel Excitation (Transmit-GRAPPA)" M.A. Giswold, S. Kannengiesser, M. Muller and P.M. Jakob, Proc. Intl. Soc. Mag. Reson. Med. 13, page 2435 (2005)

[4] "Travelling-wave nuclear magnetic resonance", D.O. Brunner, N.D. Zanche, J. Fröhlich, J. Paska, and K.P. Pruessmann, Nature, 457, pp. 994-998 (2009).

[5] "Initial results of cardiac imaging at 7 tesla", C.J. Snyder, L. Delabarre, G.J. Metzger, P.-F. van de Moortele, C. Akgun, K. Ugurbil, and J.T. Vaughan. Magnetic Resonance Imaging, 61, pp. 517 - 524 (2009).

[6] "Counteracting radio frequency inhomogeneity in the human brain at 7 Tesla using strongly modulated pulses", N. Boulant, N. Mangin, and A. Amadon, Magnetic Resonance in Medicine, 61, pp. 1165-1172 (2009).

[7] Berstein MA, King KF, Zhou XJ, "Handbook of MRI Pulse Sequences", London: Elsevier Academic Press; 2004.

[8] "Transmit SENSE", U. Katscher, P. Bornert, C.Leussler, and JS vd Brink, Magnetic Resonance in Medicine, 49, pp. 144-150 (2003).

[9] "Parallel RF transmission with eight channels at 3 Tesla", K. Setsompop, L.L. Wald, V. Alagappan, B. Gagoski, F. Hebrank, U. Fontius, F. Schmitt, and E. Adalsteinsson, Magnetic Resonance in Medicine, 56, pp. 1163-1171 (2006).

[10] "Slice-Selective RF Pulses for In Vivo B1+ Inhomogeneity Mitigation at 7 Tesla Using Parallel RF Excitation With a 16-Element Coil", K Setsompop, V. Alagappan, B. Gagoski, T. Witzel, J. Polimeni, A. Potthast, F. Hebrank, U. Fontius, F. Schmitt, L.L. Wald, and E. Adalsteinsson, Magnetic Resonance in Medicine, 60, pp. 1422-1432 (2008).

[11] "Broadband Slab Selection with B1□ Mitigation at 7T via Parallel Spectral-Spatial Excitation", K Setsompop, V. Alagappan, B. Gagoski, A. Potthast, F. Hebrank, U. Fontius, F. Schmitt, LL Wald, and E Adalsteinsson, Magnetic Resonance in Medicine, 61, pp 493-500 (2009).

[12] "Experimental analysis of parallel excitation using dedicated coil setups and simultaneous RF transmission on multiple channels", P. Ullmann, S. Junge, M.Wick, F. Seifert, W. Ruhm, and J. Hennig, Magnetic Resonance in Medicine, 54, pp. 994-1001 (2005).

[13] "Specific Absorption Rate Studies of the Parallel Transmission of Inner-Volume Excitations at 7 Tesla", A.C. Zelinski, L.M. Angelone, V.K. Goyal, G. Bonmassar, E. Adalsteinsson and L.L. Wald, Journal of magnetic resonance imaging, 28, pp. 1005-1008 (2008).

[14] "A Conservative Method for Ensuring Safety within Transmit Arrays",C.M. Collins, Z. Wang, and M.B. Smith. 15th Proceedings of the Annual Meeting of the ISMRM, p 1092 (2007).

[15] "Determination of Electric Conductivity and Local SAR via B1 Mapping.",U. katcher, T. Voigt, C Findeklee, P. Vernickel, K. Nehrke, and O. Doessel. 16th Proceedings of the Annual Meeting of the ISMRM, p 1191 (2008).

[16] "Towards Direct B1 Based Local SAR Estimation", M.A. Cloos, and G. Bonmassar. 17th Proceedings of the Annual Meeting of the ISMRM, p 3037 (2009).

[17] "Imaging Conductivity and Local SAR of the Human Brain",T. Voigt, O. Doessel, and U. Katscher, 17th Proceedings of the Annual Meeting of the ISMRM, p 4513 (2009).

[18] "Real-time global and local SAR monitoring for parallel transmission systems", I. Graesslin, S. Biederer, B. Annighoefer, H Hofmann, H. Stahl, P. Vernickle, U. Katscher, D. Glaesel, and P Harvey , 17th Proceedings of the Annual Meeting of the ISMRM, p 302 (2009)

[19] "Fast E1, B1 and SAR simulation with the use of graphics processors", L. Kini, L.L. Wald, and E. Adalsteinsson, 17th Proceedings of the Annual Meeting of the ISMRM, p 4776 (2009).

[20] "Designing RF pulses with optimal specific absorption rate (SAR) characteristics and exploring excitation fidelity, SAR fidelity, and pulse duration tradeoffs", A.C. Zelinski, V.K. Goyal, L. Angelone, G. Bonmassar, L.L. Wald, and E. Adalsteinsson, 15th Proceedings of the Annual Meeting of the ISMRM, p 1699 (2007).

[21] "Pulse design methods for reduction of specific absorption rate in parallel RF excitation", A.C. Zelinski, K. Setsompop, V. Alagappan, B.A. Gagoski, L. Angelone, G. Bonmassar, U. Fontius, F. Schmitt, E. Adalstelnsson, and L.L. Wald, 15th Proceedings of the Annual Meeting of the ISMRM, p 1698 (2007).

[22] "SAR hotspot reduction by temporal averaging in parallel transmission", I. Graesslin, J. Weller, B. Annighoefer, S. Biederer, U. Katscher, T. Nielsen, P. Harvey, and P Bornmet , 17th Proceedings of the Annual Meeting of the ISMRM, p 176 (2009).

[23] "A Minimum SAR RF Pulse Design Approach for Parallel Tx with Local Hot Spot Suppression and Exact Fidelity Constraint", I. Graesslin, F Schweser, B. Annighoefer, S Biederer, U Katscher, K. Nehrke, H Stahl, H Dingemans, G Mens, and P Börnert, 16th Proceedings of the Annual Meeting of the ISMRM, p 621 (2008).

[24] "SAR reduction in transmit SENSE using adapted excitation k-space trajectories", X. Wu, C. C Akgun, J.T. Vaughan, K. Gerbil, and P.-F. van der Moortele, 15th Proceedings of the Annual Meeting of the ISMRM, p 673 (2007).

[25] "Fast slice-selective radio-frequency excitation pulses for mitigating B+l inhomogeneity in the human brain at 7 Tesla", A.C. Zelinski, L.L. Wald, K. Setsompop, V. Alagappan, B.A. Gagoski, V.K. Goyal, and E. Adalsteinsson, Magnetic Resonance in Medicine, 59, pp. 1355-1364 (2008).

[26] "Saturated Double-Angle Method for Rapid B1+ Mapping", C.H. Cunningham, J.M. Pauly, and K.S. Nayak, Magnetic Resonance in Medicine, 55, pp. 1326-1333 (2006).

[27] "Actual flip-angle imaging in the pulsed steady state: A method for rapid three-dimensional mapping of the transmitted radiofrequency field", V.L. Yarnykh, Magnetic Resonance in Medicine, 57, pp. 192-200 (2007).

[28] " Large-Scale Simulations Including a Human-Body Model for MRI" Vogel MH, and Kleihorst RP. Microwave Symposium IEEE/MTT-S, pp. 1345-1348 (2007)

[29] "Magnitude Least Squares Optimization for Parallel Radio Frequency Excitation Desin Demonstrated at 7 Tesla With Eight Channels", K. Setsompop et al., Magnetic Resonance in Medicine, 59, pp. 908-915 (2008).

[30] "A Noniterative Method to Design Large-Tip-Angle Multidimensional Spatially-Selective Radio Frequency Pulses for Parallel Transmission ", D. Xu et al., Magnetic Resonance in Medicine, 58, pp. 326-334 (2007).

[31] "Temperature Mapping Using the Water Proton Chemical Shift: A Chemical Shift Selective Phase Mapping Method", J. Kuroda et al. MRM 38:845-851 (1997).

[32] "Additive Angle Method for Fast Large-Tip-Angle RF Pulse Design in Parallel Excitation", W. A. Grissom et al. Magnetic Resonance in Medicine, 59:779-787 (2008).

[33] "Iterative RF Pulse Design for Multidimensional Small-Tip-Angle Selective Excitation", C. Yip et al, Magn Reson Med 54: 908-917, 2005

[34] US 2009/108842

## Claims

1. A method of exciting nuclear spins in a sample (H), wherein a plurality of transmit coils ($C_1$-$C_8$) are driven in parallel to emit respective radio-frequency waves, the method comprising computing waveforms of said radio-frequency waves by solving an optimization problem for minimizing the difference between a spatial distribution of nuclear spin excitation within said sample induced by said radio-frequency waves and a target spatial distribution of nuclear spin excitation, wherein said optimization problem includes a cost function depending on the power emitted by each of said transmit coils weighted by a respective coil-dependent coefficient, the cost function thereby involving a plurality of independent coil-dependent coefficients, called weighting coefficients;
   the method being **characterized in that** said waveforms of said radio-frequency waves are computed iteratively, each iteration step comprising: solving said optimization problem based on present values of the weighting coefficients, and subsequently updating the value of at least one of said coefficients so as to control in a predetermined way the local specific absorption rate - SAR - spatial distribution within the sample.

2. A method according to any of the preceding claims wherein the value of at least one of said weighting coefficients is updated so as to reduce the local maximum of the SAR spatial distribution within the sample.

3. A method according to claim 2 comprising, at each iteration step, the determination of a transmit coil which is closest to the local maximum of the SAR spatial distribution within the sample and an increment of the value of the weighting coefficient of at least said transmit coil.

4. A method according to claim 3 comprising determining, at each iteration step, the point of the sample volume where the local SAR takes its maximum value, by a method chosen between:

- numerical simulation;
- direct SAR measurement via $B_1^+$ mapping; and
- temperature mapping.

**5.** A method according to claim 2 comprising, at each iteration step, an increment of the value of the weighting coefficient of at least the transmit coil which transmits the greatest radio-frequency power.

**6.** A method according to claim 2 comprising, at each iteration step, an increment of the value of the weighting coefficient of at least the transmit coil or coils whose transmitted radio-frequency power exceeds a predetermined threshold.

**7.** A method according to claim 1 wherein the value of at least one of said weighting coefficients is updated so as to ensure that the local SAR takes its maximum value within a predetermined region of the sample.

**8.** A method according to claim 7 wherein the value of at least one of said weighting coefficients is updated so as to reduce the local maximum of the SAR spatial distribution within the sample, excluding said predetermined region thereof.

**9.** A method according to claim 8 wherein , at each iteration step, the value of the weighting coefficient of at least the transmit coil which is closest to the local maximum of the SAR spatial distribution within the sample, excluding said predetermined region thereof, is increased.

**10.** A method according to claim 7 comprising, at each iteration step, an increment of the value of the weighting coefficient of at least the transmit coil which transmits the greatest radio-frequency power, excluding a set of N coils which are the N nearest coils to said predetermined region of the sample.

**11.** A method of exciting nuclear spins in a sample, wherein a method according to any of claims 7 to 10 is repeated at least twice by changing the predetermined region of the sample where the local SAR takes its maximum value.

**12.** A method according to any of the preceding claims, wherein the cost function depends linearly on the power emitted by said transmit coils, and wherein said weighting coefficients are Tikhonov parameters.

**13.** A method according to any of the preceding claims, wherein said target excitation distribution is a uniform distribution within the sample or a region thereof.

**14.** A method according to any of the preceding claims, wherein said optimization problem is solved in the spatial domain.

**15.** A method according to any of the preceding claims, wherein said weighting coefficients are time-dependent.

**16.** A method of performing nuclear magnetic resonance imaging of a sample comprising:

- determining a k-space trajectory for sampling the volume of said sample; and
- exciting nuclear spins in said sample by a method according to any of the preceding claims, the optimization problem being solved for said k-space trajectory.

**17.** A method according to any of the preceding claims wherein the sample is a human or animal body, or a part thereof.

**Patentansprüche**

**1.** Verfahren zur Anregung von Kernspins in einer Probe (H), bei dem eine Mehrzahl an Sendespulen ($C_1$-$C_8$) parallel angesteuert wird, um jeweils entsprechende Radiofrequenzwellen auszusenden, wobei
das Verfahren Berechnen der Wellenformen der Radiofrequenzwellen durch Lösen eines Optimierungsproblems zur Minimierung der Differenz zwischen einer durch die Radiofreguenzwellen hervorgerufenen räumlichen Verteilung der Kernspinanregung innerhalb der Probe und einer räumlichen Ziel-Verteilung der Kernspinanregung umfasst, wobei
das Optimierungsproblem eine Kostenfunktion beinhaltet, welche von der durch einen entsprechenden spulenabhängigen Koeffizienten gewichteten von jeder der Sendespulen ausgesandten Leistung abhängig ist und die Kostenfunktion daher eine Mehrzahl unabhängiger spulenabhängiger Koeffizienten, Gewichtungskoeffizienten genannt, beinhaltet;

**dadurch gekennzeichnet, dass**

die Wellenformen der Radiofrequenzwellen iterativ berechnet werden, wobei jeder Iterationsschritt ein Lösen des Optimierungsproblems basierend auf den aktuellen Werten der Gewichtungskoeffizienten und ein darauffolgendes Aktualisieren des Wertes zumindest eines der Gewichtungskoeffizienten zur Kontrolle der räumlichen Verteilung der lokalen spezifischen Absorptionsrate -SAR- innerhalb der Probe auf vorherbestimmte Weise, umfasst.

2. Verfahren nach einem der vorhergehenden Ansprüche, wobei der Wert zumindest eines der Gewichtungskoeffizienten aktualisiert wird, um das lokale Maximum der räumlichen SAR-Verieilung innerhalb der Probe zu reduzieren.

3. Verfahren nach Anspruch 2, welches bei jedem Iterationsschritt die Erfassung der dem lokalen Maximum der räumlichen SAR- Verteilung nächstgelegenen Sendespule und eine Inkrementierung des Wertes des Gewichtungskoeffizienten zumindest dieser Spule umfasst.

4. Verfahren nach Anspruch 3, welches bei jedem Iterationsschritt ein Erfassen des Punktes des Probenvolumens, an dem die lokale SAR ihren Maximalwert annimmt, durch eines der folgenden Verfahren umfasst:

   - numerische Simulation
   - direkte SAR- Messung durch B1*-Mapping (bzw. B1*-Abbildung)
   - Temperatur-Mapping (bzw. Temperatur-Abbildung)

5. Verfahren nach Anspruch 2, welches bei jedem Iterationsschritt eine Inkrementierung des Wertes des Gewichtungskoeffizienten zumindest der Sendespule, welche die größte Radiofrequenzleistung sendet, umfasst.

6. Verfahren nach Anspruch 2, welches bei jedem Iterationsschritt eine Inkrementierung des Wertes des Gewichtungskoeffizienten zumindest der Sendespule oder -spulen, deren ausgesandte Radiofrequenzleistung einen vorherbestimmten Schwellenwert überschreitet, umfasst.

7. Verfahren nach Anspruch 1, wobei der Wert zumindest eines der Gewichtungskoeffizienten aktualisiert wird, um sicherzustellen, dass die lokale SAR ihren Maximalwert innerhalb eines vorherbestimmten Bereichs der Probe annimmt.

8. Verfahren nach Anspruch 7, wobei der Wert zumindest eines der Gewichtungskoeffizienten aktualisiert wird, um das lokale Maximum der räumlichen SAR-Verteilung innerhalb der Probe zu reduzieren, wobei der vorherbestimmte Bereich hiervon ausgeschlossen wird.

9. Verfahren nach Anspruch 8, wobei bei jedem Iterationsschritt der Wert des Gewichtungskoeffizienten zumindest der dem lokalen Maximum der räumlichen SAR-Verteilung innerhalb der Probe nächstgelegenen Sendespule, unter Ausschluss des vorherbestimmten Bereichs, inkrementiert wird.

10. Verfahren nach Anspruch 7, welches bei jedem Iterationsschritt eine Inkrementierung des Wertes des Gewichtungskoeffizienten zumindest der Sendespule, welche die größte Radiofrequenzleistung unter Ausschluss eines Satzes von N Spulen, die die N dem vorherbestimmten Bereich nächstgelegenen Spulen sind, aussendet, umfasst.

11. Verfahren zur Anregung von Kernspins in einer Probe, bei dem ein Verfahren nach einem der Ansprüche 7 bis 10 mindestens zweimal durch Wechseln des vorherbestimmten Bereichs, in dem die lokale SAR ihren Maximalwert annimmt, wiederholt wird.

12. Verfahren nach einem der vorhergehenden Ansprüche, bei dem die Kostenfunktion linear von der von den Sendespulen ausgesandten Leistung abhängig ist und die Gewichtungskoeffizienten Thikonov-Parameter sind.

13. Verfahren nach einem der vorhergehenden Ansprüche, bei dem die Ziel-Verteilung der Anregung eine einheitliche Verteilung innerhalb der Probe oder eines Bereichs davon, ist.

14. Verfahren nach einem der vorhergehenden Ansprüche, bei dem das Optimierungsproblem im räumlichen Bereich gelöst wird.

15. Verfahren nach einem der vorhergehenden Ansprüche, bei dem die Gewichtungskoeffizienten zeitabhängig sind.

**16.** Verfahren zur Durchführung einer Magnetresonanztomographie einer Probe, umfassen:

- Festlegen einer k-Raum-Bewegungsbahn zum Abtasten des Volumens der Probe, und
- Anregen von Kernspins in der Probe durch ein Verfahren nach einem der vorhergehenden Ansprüche, wobei das Optimierungsproblem für die k-Raum-Bewegungsbahn gelöst wird.

**17.** Verfahren nach einem der vorhergehenden Ansprüche, wobei die Probe der Körper eines Menschen oder Tieres, oder ein Teil davon, ist.

**Revendications**

**1.** Procédé d'excitation de spins nucléaires dans un échantillon (H), dans lequel une pluralité de bobines d'émission ($C_1$ à $C_8$) sont pilotées en parallèle afin d'émettre des ondes radiofréquence respectives, le procédé comprenant le calcul de formes d'onde desdites ondes radiofréquence en résolvant un problème d'optimisation afin de minimiser la différence entre une répartition spatiale d'excitation de spins nucléaires à l'intérieur dudit échantillon induite par lesdites ondes radiofréquence et une répartition spatiale cible d'excitation de spins nucléaires, dans lequel ledit problème d'optimisation comprend une fonction de coût dépendant de la puissance émise par chacune desdites bobines d'émission pondérée par un coefficient respectif dépendant de la bobine, la fonction de coût impliquant ainsi une pluralité de coefficients indépendants, dépendant chacun d'une bobine, appelés coefficients de pondération ;
le procédé étant **caractérisé en ce que** lesdites formes d'onde desdites ondes radiofréquence sont calculées de façon itérative, chaque étape d'itération comprenant :

la résolution dudit problème d'optimisation en se basant sur des valeurs actuelles des coefficients de pondération, et la mise à jour ultérieure de la valeur d'au moins l'un desdits coefficients afin de réguler de façon prédéterminée la répartition spatiale de débit d'absorption spécifique - DAS - local à l'intérieur de l'échantillon.

**2.** Procédé selon l'une quelconque des revendications précédentes, dans lequel la valeur d'au moins l'un desdits coefficients de pondération est mise à jour de façon à réduire le maximum local de la répartition spatiale de DAS à l' intérieur de l' échantillon.

**3.** Procédé selon la revendication 2, comprenant, à chaque étape d'itération, la détermination d'une bobine d'émission qui est la plus proche du maximum local de la répartition spatiale de DAS à l'intérieur de l'échantillon et un incrément de la valeur du coefficient de pondération d'au moins ladite bobine d' émission.

**4.** Procédé selon la revendication 3, comprenant la détermination, à chaque étape d'itération, du point du volume d'échantillon où le DAS local prend sa valeur maximale, par un procédé choisi entre :

- la simulation numérique ;
- la mesure de DAS directe via un mappage $B_1^+$; et
- la cartographie de température.

**5.** Procédé selon la revendication 2, comprenant, à chaque étape d'itération, un incrément de la valeur du coefficient de pondération d'au moins la bobine d'émission qui émet la plus grande puissance radiofréquence.

**6.** Procédé selon la revendication 2, comprenant, à chaque étape d'itération, un incrément de la valeur du coefficient de pondération d'au moins la bobine d'émission ou de bobines dont la puissance radiofréquence émise dépasse un seuil prédéterminé.

**7.** Procédé selon la revendication 1, dans lequel la valeur d'au moins l'un desdits coefficients de pondération est mise à jour de façon à s'assurer que le DAS local prend sa valeur maximale à l'intérieur d'une région prédéterminée de l'échantillon.

**8.** Procédé selon la revendication 7, dans lequel la valeur d'au moins l'un desdits coefficients de pondération est mise à jour de façon à réduire le maximum local de la répartition spatiale de DAS à l'intérieur de l'échantillon, sauf dans ladite région prédéterminée de celui-ci.

**9.** Procédé selon la revendication 8, dans lequel, à chaque étape d'itération, la valeur du coefficient de pondération d'au moins la bobine d'émission qui est la plus proche du maximum local de la répartition spatiale de DAS à l'intérieur de l'échantillon, sauf dans ladite région prédéterminée de celui-ci, est augmentée.

**10.** Procédé selon la revendication 7, comprenant, à chaque étape d'itération, un incrément de la valeur du coefficient de pondération d'au moins la bobine d'émission qui émet la plus grande puissance radiofréquence, en excluant un ensemble de N bobines qui sont les N bobines les plus proches de ladite région prédéterminée de l'échantillon.

**11.** Procédé d'excitation de spins nucléaires dans un échantillon, dans lequel un procédé selon l'une quelconque des revendications 7 à 10 est répété au moins deux fois en changeant la région prédéterminée de l'échantillon où le DAS local prend sa valeur maximale.

**12.** Procédé selon l'une quelconque des revendications précédentes, dans lequel la fonction de coût dépend linéairement de la puissance émise par lesdites bobines d'émission, et dans lequel lesdits coefficients de pondération sont des paramètres de Tikhonov.

**13.** Procédé selon l'une quelconque des revendications précédentes, dans lequel ladite répartition d'excitation cible est une répartition uniforme à l'intérieur de l'échantillon ou d'une région de celui-ci.

**14.** Procédé selon l'une quelconque des revendications précédentes, dans lequel ledit problème d'optimisation est résolu dans le domaine spatial.

**15.** Procédé selon l'une quelconque des revendications précédentes, dans lequel lesdits coefficients de pondération dépendent du temps.

**16.** Procédé de réalisation d'une imagerie par résonance magnétique nucléaire d'un échantillon comprenant :

- la détermination d'une trajectoire dans un k-espace pour échantillonner le volume dudit échantillon ; et
- l'excitation de spins nucléaires dudit échantillon par un procédé selon l'une quelconque des revendications précédentes, le problème d'optimisation étant résolu pour ladite trajectoire dans le k-espace.

**17.** Procédé selon l'une quelconque des revendications précédentes, dans lequel l'échantillon est un corps humain ou animal, ou une partie de celui-ci.

Fig.1

Initial weighting coefficients

Calculate excitation pulse

Calculate 10-gram local SAR

Optimized weighting coefficients

Update weighting coefficients

Fig.2

Spokes locations

a

b

c

d

Fig.3

Fig.4

Fig.5

Fig.6

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 2009108842 A

**Non-patent literature cited in the description**

- **W. GRISSOM ; C.Y. YIP ; Z. ZHANG ; V.A. STENGER ; J.A. FESSLER ; D. C. NOLL.** Spatial domain method for the design of RF pulses in multicoil parallel excitation. *Magnetic Resonance in Medicine,* 2006, vol. 56, 620-629
- **Y. ZHU.** Parallel Excitation With an Array of Transmit Coils. *Magnetic Resonance in Medicine,* 2004, vol. 51, 775-784
- **M.A. GISWOLD ; S. KANNENGIESSER ; M. MULLER ; P.M. JAKOB.** Autocalibrated Accelerated Parallel Excitation (Transmit-GRAPPA. *Proc. Intl. Soc. Mag. Reson. Med.,* 2005, vol. 13, 2435
- **D.O. BRUNNER ; N.D. ZANCHE ; J. FRÖHLICH ; J. PASKA ; K.P. PRUESSMANN.** Travelling-wave nuclear magnetic resonance. *Nature,* 2009, vol. 457, 994-998
- **C.J. SNYDER ; L. DELABARRE ; G.J. METZGER ; P.-F. VAN DE MOORTELE ; C. AKGUN ; K. UGURBIL ; J.T. VAUGHAN.** Initial results of cardiac imaging at 7 tesla. *Magnetic Resonance Imaging,* 2009, vol. 61, 517-524
- **N. BOULANT ; N. MANGIN ; A. AMADON.** Counteracting radio frequency inhomogeneity in the human brain at 7 Tesla using strongly modulated pulses. *Magnetic Resonance in Medicine,* 2009, vol. 61, 1165-1172
- **BERSTEIN MA ; KING KF ; ZHOU XJ.** Handbook of MRI Pulse Sequences. Elsevier Academic Press, 2004
- **U. KATSCHER ; P. BORNERT ; C.LEUSSLER ; JS VD BRINK.** Transmit SENSE. *Magnetic Resonance in Medicine,* 2003, vol. 49, 144-150
- **K. SETSOMPOP ; L.L. WALD ; V. ALAGAPPAN ; B. GAGOSKI ; F. HEBRANK ; U. FONTIUS ; F. SCHMITT ; E. ADALSTEINSSON.** Parallel RF transmission with eight channels at 3 Tesla. *Magnetic Resonance in Medicine,* 2006, vol. 56, 1163-1171
- **K SETSOMPOP ; V. ALAGAPPAN ; B. GAGOSKI ; T. WITZEL ; J. POLIMENI ; A. POTTHAST ; F. HEBRANK ; U. FONTIUS ; F. SCHMITT ; L.L. WALD.** Slice-Selective RF Pulses for In Vivo B1+ Inhomogeneity Mitigation at 7 Tesla Using Parallel RF Excitation With a 16-Element Coil. *Magnetic Resonance in Medicine,* 2008, vol. 60, 1422-1432

- **K SETSOMPOP ; V. ALAGAPPAN ; B. GAGOSKI ; A. POTTHAST ; F. HEBRANK ; U. FONTIUS ; F. SCHMITT ; LL WALD ; E ADALSTEINSSON.** Broadband Slab Selection with B1□ Mitigation at 7T via Parallel Spectral-Spatial Excitation. *Magnetic Resonance in Medicine,* 2009, vol. 61, 493-500
- **P. ULLMANN ; S. JUNGE ; M.WICK ; F. SEIFERT ; W. RUHM ; J. HENNIG.** Experimental analysis of parallel excitation using dedicated coil setups and simultaneous RF transmission on multiple channels. *Magnetic Resonance in Medicine,* 2005, vol. 54, 994-1001
- **A.C. ZELINSKI ; L.M. ANGELONE ; V.K. GOYAL ; G. BONMASSAR ; E. ADALSTEINSSON ; L.L. WALD.** Specific Absorption Rate Studies of the Parallel Transmission of Inner-Volume Excitations at 7 Tesla. *Journal of magnetic resonance imaging,* 2008, vol. 28, 1005-1008
- **C.M. COLLINS ; Z. WANG ; M.B. SMITH.** A Conservative Method for Ensuring Safety within Transmit Arrays. *15th Proceedings of the Annual Meeting of the ISMRM,* 2007, 1092
- **U. KATCHER ; T. VOIGT ; C FINDEKLEE ; P. VERNICKEL ; K. NEHRKE ; O. DOESSEL.** Determination of Electric Conductivity and Local SAR via B1 Mapping. *16th Proceedings of the Annual Meeting of the ISMRM,* 2008, 1191
- **M.A. CLOOS ; G. BONMASSAR.** Towards Direct B1 Based Local SAR Estimation. *17th Proceedings of the Annual Meeting of the ISMRM,* 2009, 3037
- **T. VOIGT ; O. DOESSEL ; U. KATSCHER.** Imaging Conductivity and Local SAR of the Human Brain. *17th Proceedings of the Annual Meeting of the ISMRM,* 2009, 4513
- **I. GRAESSLIN ; S. BIEDERER ; B. ANNIGHOEFER ; H HOFMANN ; H. STAHL ; P. VERNICKLE ; U. KATSCHER ; D. GLAESEL ; P HARVEY.** Real-time global and local SAR monitoring for parallel transmission systems. *17th Proceedings of the Annual Meeting of the ISMRM,* 2009, 302

- **L. KINI ; L.L. WALD ; E. ADALSTEINSSON.** Fast E1, B1 and SAR simulation with the use of graphics processors. *17th Proceedings of the Annual Meeting of the ISMRM,* 2009, 4776
- **A.C. ZELINSKI ; V.K. GOYAL ; L. ANGELONE ; G. BONMASSAR ; L.L. WALD ; E. ADALSTEINSSON.** Designing RF pulses with optimal specific absorption rate (SAR) characteristics and exploring excitation fidelity, SAR fidelity, and pulse duration tradeoffs. *15th Proceedings of the Annual Meeting of the ISMRM,* 2007, 1699
- **A.C. ZELINSKI ; K. SETSOMPOP ; V. ALAGAPPAN ; B.A. GAGOSKI ; L. ANGELONE ; G. BONMASSAR ; U. FONTIUS ; F. SCHMITT ; E. ADALSTELNSSON ; L.L. WALD.** Pulse design methods for reduction of specific absorption rate in parallel RF excitation. *15th Proceedings of the Annual Meeting of the ISMRM,* 2007, 1698
- **I. GRAESSLIN ; J. WELLER ; B. ANNIGHOEFER ; S. BIEDERER ; U. KATSCHER ; T. NIELSEN ; P. HARVEY ; P BORNMET.** SAR hotspot reduction by temporal averaging in parallel transmission. *17th Proceedings of the Annual Meeting of the ISMRM,* 2009, 176
- **I. GRAESSLIN ; F SCHWESER ; B. ANNIGHOEFER ; S BIEDERER ; U KATSCHER ; K. NEHRKE ; H STAHL ; H DINGEMANS ; G MENS ; P BÖRNERT.** A Minimum SAR RF Pulse Design Approach for Parallel Tx with Local Hot Spot Suppression and Exact Fidelity Constraint. *16th Proceedings of the Annual Meeting of the ISMRM,* 2008, 621
- **X. WU ; C. C AKGUN ; J.T. VAUGHAN ; K. GERBIL ; P.-F. VAN DER MOORTELE.** SAR reduction in transmit SENSE using adapted excitation k-space trajectories. *15th Proceedings of the Annual Meeting of the ISMRM,* 2007, 673
- **A.C. ZELINSKI ; L.L. WALD ; K. SETSOMPOP ; V. ALAGAPPAN ; B.A. GAGOSKI ; V.K. GOYAL ; E. ADALSTEINSSON.** Fast slice-selective radio-frequency excitation pulses for mitigating B+l inhomogeneity in the human brain at 7 Tesla. *Magnetic Resonance in Medicine,* 2008, vol. 59, 1355-1364
- **C.H. CUNNINGHAM ; J.M. PAULY ; K.S. NAYAK.** Saturated Double-Angle Method for Rapid B1+ Mapping. *Magnetic Resonance in Medicine,* 2006, vol. 55, 1326-1333
- **V.L. YARNYKH.** Actual flip-angle imaging in the pulsed steady state: A method for rapid three-dimensional mapping of the transmitted radiofrequency field. *Magnetic Resonance in Medicine,* 2007, vol. 57, 192-200
- **VOGEL MH ; KLEIHORST RP.** Large-Scale Simulations Including a Human-Body Model for MRI. *Microwave Symposium IEEE/MTT-S,* 2007, 1345-1348
- **K. SETSOMPOP et al.** Magnitude Least Squares Optimization for Parallel Radio Frequency Excitation Desin Demonstrated at 7 Tesla With Eight Channels. *Magnetic Resonance in Medicine,* 2008, vol. 59, 908-915
- **D. XU et al.** A Noniterative Method to Design Large-Tip-Angle Multidimensional Spatially-Selective Radio Frequency Pulses for Parallel Transmission. *Magnetic Resonance in Medicine,* 2007, vol. 58, 326-334
- **J. KURODA et al.** Temperature Mapping Using the Water Proton Chemical Shift: A Chemical Shift Selective Phase Mapping Method. *MRM,* 1997, vol. 38, 845-851
- **W. A. GRISSOM et al.** Additive Angle Method for Fast Large-Tip-Angle RF Pulse Design in Parallel Excitation. *Magnetic Resonance in Medicine,* 2008, vol. 59, 779-787
- **C. YIP et al.** Iterative RF Pulse Design for Multidimensional Small-Tip-Angle Selective Excitation. *Magn Reson Med,* 2005, vol. 54, 908-917